(19) Europäisches Patentamt

European Patent Office

Office européen des brevets

(11) **EP 3 281 032 B1**

(12) **EUROPEAN PATENT SPECIFICATION**

(45) Date of publication and mention
of the grant of the patent:
**25.12.2019 Bulletin 2019/52**

(21) Application number: **15888625.9**

(22) Date of filing: **09.04.2015**

(51) Int Cl.:
*G01S 7/03* (2006.01)    *G01S 13/78* (2006.01)
*H03F 1/02* (2006.01)    *H03F 3/21* (2006.01)
*H01Q 25/02* (2006.01)    *G01S 13/02* (2006.01)
*H01Q 3/36* (2006.01)    *H01Q 21/06* (2006.01)

(86) International application number:
**PCT/SE2015/050422**

(87) International publication number:
**WO 2016/163925 (13.10.2016 Gazette 2016/41)**

(54) **AN IMPROVED ANTENNA SYSTEM FOR PROVIDING IDENTIFICATION FUNCTIONALITY**

VERBESSERTES ANTENNENSYSTEM ZUR BEREITSTELLUNG VON
IDENTIFIZIERUNGSFUNKTIONALITÄT

SYSTÈME D'ANTENNE AMÉLIORÉ POUR FOURNIR UNE FONCTIONNALITÉ D'IDENTIFICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**14.02.2018 Bulletin 2018/07**

(73) Proprietor: **Saab AB
581 88 Linköping (SE)**

(72) Inventors:
• **SVENSSON, Bengt
S-431 66 Mölndal (SE)**
• **ILLIPE, Hannes
S-439 73 Fjärås (SE)**

(74) Representative: **Zacco Sweden AB
P.O. Box 5581
114 85 Stockholm (SE)**

(56) References cited:
WO-A1-01/27654          WO-A1-2010/141661
CN-A- 103 558 594      US-A- 3 387 299
US-A1- 2014 313 071   US-B2- 8 674 872

• GIL WONG CHOI ET AL: "High efficiency Class-E
tuned Doherty amplifier using GaN HEMT",
MICROWAVE SYMPOSIUM DIGEST, 2009. MTT
'09. IEEE MTT-S INTERNATIONAL, IEEE,
PISCATAWAY, NJ, USA, 7 June 2009
(2009-06-07), pages 925-928, XP031490671, ISBN:
978-1-4244-2803-8

**Description**

TECHNICAL FIELD

The present disclosure relates to an antenna system for identifying air-, sea- or ground-based units.

BACKGROUND

In order for e.g. military airborne units such as aircrafts to be able to identify themselves systems commonly referred to as IFF systems, Identify Friend or Foe, are used. Corresponding civil applications are generally referred to as SSR systems, Secondary Surveillance Radar systems. An example of a secondary surveillance radar system is disclosed in US 8,674,872. The antenna system of the present disclosure may be applied for both military and civil applications and is hereinafter referred to as simply identification system.

The system used for identification is based on a system developed during the Second World War and have been further developed ever since. Today there are a number of quite complex standards according to which respective signals are to be transmitted. The fundamental principle behind such identification systems is that a transceiver module, also referred to as an interrogator unit, transmits an interrogation signal. The interrogation signal is usually transmitted at 1030 MHz and comprises information regarding what type of information that is requested from the unit requested to identify itself. A transponder unit at the vehicle such as an aircraft requested to identify itself receives the transmitted interrogation signal and replies with a coded reply signal comprising the requested information. The reply signal is usually transmitted at 1090 MHz. The reply signal is received by the identification system and is subsequently decoded and processed by the transceiver module. An example of a lightweight IFF detection system is disclosed in US 3,387,299.

The identification systems are often arranged together with an ordinary (primary) radar system of e.g. a ground based radar station. Identification systems arranged together with a primary radar system can often benefit from the mechanical radar scanning rotation of the primary radar whereby the identification system also is rotated with the rotation of the primary radar. For mechanically rotated identification systems it has been possible to feed the identification system with a central, high power transmitter in order to obtain the requested transmitting power of the transmitted interrogation signal.

Today radar systems of ESA type, Electrically Steerable Antennas, are becoming more and more common. ESA radar systems provided with an amplifying device are considered to be active ESAs, AESAs. Herein ESAs as well as AESAs are referred to as electronically scanned antenna systems. Radar systems of electronically scanned antenna systems type comprise numerous small solid-state transmit and receive elements, wherein each element is configured to transmit and/or receive separate electromagnetic waves. The antenna elements together form an array of elements, referred to as an antenna array. By controlling the phase of the transmitted electromagnetic waves, wherein the numerous electromagnetic waves may interfere constructively at certain angles in front of the antenna and form a number of antenna lobes, including a main lobe, the direction of the main lobe, and other antenna lobes, of the antenna can be controlled. The antenna elements transmitting and receiving the signals may be the same antenna elements, wherein a path directing functionality controls if the antenna is in transmission or receiving mode, or be separate antennas elements used only for either transmission or reception. An example of a phased array beam forming method based on airborne equipment is disclosed in CN 103558594.

For radar systems of electronically scanned antenna systems type, which are not mechanically rotated but for which the main lobe is electrically steerable, also the identification antenna system needs to be of electronically scanned antenna systems type or the identification antenna system needs to be mechanically rotated on its own. Having a separate, mechanically rotated, identification antenna system is not very convenient. Having a separate mechanical rotator will e.g. add cost and complexity and is obviously disadvantageous from a weight and mounting perspective. For antenna systems of electronically scanned antenna systems type used for identification it is also not suitable to use a central, high power transmitter since components related to the electronically scanned antenna systems functionality, such as phase shifters etc. are not suitable for managing that high power levels, such as 4-5 kW. Phase shifters managing such high powers become heavy and bulky, making it hard to mount such components close to the antenna elements. Also, such components are associated with significant power losses. Instead identification antenna systems are generally provided with an amplifier close to the antenna structure in order to obtain sufficient transmission power.

The amplifiers used in antennas are generally of linear type or non-linear type, and generally higher linearity leads to lower efficiency. The output of an amplifier of linear type is proportional to its input, but linear amplifiers generally have low efficiency. Amplifiers are generally quite power consuming, hence it is desirable to keep the power losses associated with the amplifier as low as possible and to keep the efficiency of the amplifier as high as possible. Amplifiers of non-linear type generally have a higher efficiency, particularly at the operating mode where the amplifier is providing maximal output. This operating mode is referred to as saturation mode. Since non-linear amplifiers generally have a higher efficiency, especially when operating in saturation mode, it is preferable to use non-linear amplifiers. Examples of linear amplifiers are amplifiers of class A, AB or B type whereas examples of non-linear amplifiers are amplifiers of class C type. However, other amplifier solutions for radar applications are proposed such as for example Choi G.W. et al. High Efficiency Class-E tuned Doherty Amplifier using GaN HEMT, IEEE MTT-S Int. Microw. Symp. Dig., pp. 925-928, 2009.

The antenna elements of an antenna array, for an identification antenna system, are generally divided in two separate antenna halves. These two separate antenna halves comprise at least one antenna structure, in turn comprising at least one antenna element, each. These two antenna halves are arranged symmetrically in relation to the boresight axis of the antenna. During transmission the antenna elements of respective antenna halves may either be fed in phase, which is referred to as transmission in sum channel, or respective half of the antenna may transmit with essentially 180 degree phase offset, which is referred to as transmission in delta channel or in the difference channel. Further, it is also possible to transmit omni channel control signals, wherein such omni channel control signals are omnidirectional and may be transmitted by the same antenna system as the sum and delta channel interrogation signals or by a separate antenna system.

During operation of an IFF antenna an interrogation signal is transmitted which triggers a transponder of an aircraft or like which is present within the current direction of the main lobe of the IFF antenna. In order to avoid that transponders outside of the main lobe of the IFF antenna are triggered ISLS, Interrogator Side Lobe Suppression, is implemented. In most IFF transmitting modes the interrogation operation is performed by that three consecutive pulses are transmitted, wherein the first and the last pulses are transmitted in the sum channel and the second is transmitted in the delta or omni channel. The gain of the delta or omni radiation patterns is then usually designed to be higher than the gain in the sum radiation pattern outside the main beam. If the difference in signal strength between the transmitted signal exceeds a predetermined threshold value, it is established that the transponder is present within the main lobe of the IFF antenna. The transponder is triggered by an interrogation signal to respond by transmitting a reply signal.

In one operation mode, referred to as mode S the ISLS pulse and the interrogation signal are transmitted simultaneously. Generally the interrogation signal is transmitted in the sum channel and the ISLS pulse signal is transmitted in the delta channel.. When transmitting in the sum channel both antenna halves are fed in phase whereas when transmitting in the delta channel one half of the antenna is fed with essentially 180 degrees offset in relation to the other antenna half. Thus, when the sum and delta channel interrogation signals, which herein also simply are referred to sum and delta signals, are sent simultaneously there may be up to a doubling of the resulting transmission amplitude for the transmitting antenna half where the transmitted signals of the sum and delta channel are in phase and at least partly cancel in the transmitting antenna structure where the phase of respective signal is offset by essentially 180 degrees. The up to doubling of the resulting transmission amplitude corresponds to up to fourfold increase of required transmission power.

As previously stated, it is preferable to select amplifier such that the amplifier operate in saturation mode, which is a mode where the amplifier is operating at close to maximum output and efficiency, when transmitting at the transmission power level the antenna of the amplifier is transmitting on the predominant part of the time. When such an amplifier needs to transmit at the double transmission amplitude, thus at a fourfold increase in transmission power, there is a problem.

Thus, there is a need for further improvement.

SUMMARY

An object of the present disclosure is to provide an improved identification antenna system with minimized power losses. The object is achieved by an antenna system according to claim 1. Further objects of the present disclosure are to provide methods for using an identification system, an object which is achieved by dependent claim 8 and thereof dependent claims. Yet further advantageous aspects of the present disclosure are disclosed in the dependent claims.

When an identification antenna system operates in mode S, where the sum channel interrogation signal and the delta channel interrogation signal are transmitted simultaneously, the transmitting amplitude may be up to twice as high than if only either the sum channel interrogation signal or the delta channel interrogation signal was transmitted. The up to doubling of the transmission amplitude corresponds to an up to fourfold increase in required transmission power. If the transmission amplitude is doubled by the sum and delta channel interrogation signals being transmitted simultaneously or if there is a lower increase in transmission amplitude and transmission power depends on the phase of the sum and delta channel interrogation signals. If the sum and delta channel interrogation signals have exactly the same phase the amplitude will be essentially twice as high when the signals are transmitted simultaneously, but if they do not have exactly the same phase the resulting amplitude will be lower. The increase in transmission amplitude and transmission power is correlated to the degree of overlap between the phase of the sum and delta channel interrogation signals, wherein a large phase overlap will result in a larger amplitude and transmission power increase.

The same applies for the antenna half where the delta channel interrogation signal is sent with an up to 180 degrees offset. If the offset of the delta channel interrogation signal is essentially 180 degrees in relation to the sum channel interrogation signal, when the signal are transmitted simultaneously the resulting signal will be essentially cancelled out, but if the phase offset is not essentially 180 degrees the resulting signal will be lowered accordingly. The larger the phase overlap between the 180 degree offset sum and delta channel interrogation signals are, the larger will the cancelling effect be.

Transmitter power and receiver power sensitivity are absolute power levels which generally are expressed in watts, W. Decibel, dB, is a logarithmic unit used to express the ratio between two values of a physical quantity, such as e.g. power or intensity. For transmitting power of antennas, which is measured in watts, W, amplification of transmitting power of an antenna system can be expressed by using dBW or dBm (dBmW). The amplification of amplifiers simply expresses the power increase of the incoming signal in relation to the outgoing signal, thus in/out.

Transmission path degradation is a relative value and is generally independent of the actual power level involved. Transmission path degradation may involve a combination of factors, such as e.g. attenuation or dispersion, and will herein be referred to simply as power loss. Power loss may be expressed in dB or % of attenuation. Also power increase of transmission power is generally independent of the actual power levels involved, thus is a relative value which may be expressed in dB.

The relation between P(W) and P(dBm), wherein P(W) is the absolute power expressed in watts and P(dBm) is the absolute power expressed in dBm is:

$$P(dBm) = 10*\log(1*[P(mW)/1(mW)]) \qquad (1)$$

Generally three operation modes when transmitting in mode S may be realized; a first operating mode where the exact phase offset between the sum and delta channel interrogation signals is unknown, wherein the maximum transmission power increase is up to 6 dB,
a second operating mode where the phase of the sum and delta channel interrogation signals are controlled and the sum and delta channel interrogation signals are controlled to be in phase, giving a transmission power increase of 6 dB and a third operating mode where the phase of the sum and delta channel interrogation signals is controlled to be essentially 90 degrees offset, resulting in that for the antenna half where the sum and delta channel interrogation signals are essentially in phase a 3 dB transmission power increase is required.

The present disclosure provides an antenna system for providing identification functionality. The antenna system of the present disclosure comprises an antenna with at least two antenna structures, wherein each antenna structure comprises at least one antenna element, whereby the two antenna halves are formed.

Further, the antenna system comprises:

a transceiver module, configured at least to generate a sum channel interrogation signal and a delta channel interrogation signal for transmission, and to subsequently process and decode received reply signals,
a signal processing means
configured to process provided sum channel interrogation signal and delta channel interrogation signals into transmission signals. The signal processing means comprises a sum and a delta port configured to generate a sum and a delta channel interrogation signal with a respective sum and delta radiation pattern in transmission. In reception mode the signal processing means generate a sum and delta receive signal adding and subtracting the received signals of the two antenna halves, The signal processing means, which may be one or a plurality of components together providing the functionality of adding and subtracting signals, may e.g. be in form of a 180-degree hybrid.

Additionally, the antenna system comprises:
at least two transmit-receive modules configured at least to transmit a transmission signal provided by the signal processing means by means of the antenna structure. When the antenna system is in operation the transceiver modules are connected to the signal processing means, the signal processing means is connected to the transmit-receive modules and the transmit-receive modules are connected to the antenna structures. In order to simplify the forthcoming disclosure of the present disclosure the signal processing means will hereinafter simply be referred to as the 180-degree hybrid.

The antenna system of the present disclosure is further characterized in that each transmit-receive module is provided with an amplifying circuitry. The amplifying circuitry of respective transmit-receive module comprises:
a splitter node, wherein the splitter node is configured to split the transmission signal in at least a first and a second amplifier signal.

Further, the amplifying circuitry of respective transmit-receive module comprises:

a main power amplifier circuit, wherein the main power amplifier circuit comprises a main amplifier, wherein the main amplifier is configured to amplify the first amplifier signal,

an auxiliary power amplifier circuit, wherein the auxiliary power amplifier circuit comprises an auxiliary amplifier, wherein the auxiliary amplifier is configured to amplify the second amplifier signal, and

a power combiner node, wherein the power combiner node combines (at least) the first and second amplifier signals of the main power amplifier circuit and the auxiliary power amplifier circuit. The main power amplifier circuit and the auxiliary power amplifier circuit are provided in parallel between the power splitter node and the power combiner node.

According to one aspect of the present disclosure instead of a delta channel interrogation signal an omni channel control signal is generated at the transceiver module through the antenna delta port. Further, any aspect, or a combination of aspects, of the present disclosure applies also when an omni channel control signal is used as delta port input signal instead of a delta channel interrogation signal.

The basic principle behind the amplifying circuitry is the same as utilized in Doherty amplifiers. Doherty amplifiers are e.g. used in wireless applications. For a Doherty amplifier, which also can be considered to comprise a main and an auxiliary amplifier, a power splitter node and a power combiner node, the main amplifier is preferably of class AB type and the auxiliary amplifier is preferably of class C type.

Consider an example of a Doherty amplifier wherein the power splitter node splits up incoming signal in two equal amplifier signals (the splitting of the input power in respect to the output power and gain of the main and auxiliary amplifier will be discussed more in detail later); At operation where the power of the input signal is high the input signal is split by the power splitter node, dividing the input power equally to each amplifier with a 90 degrees difference in phase. The split signals reach the main and auxiliary amplifiers, and after the signals are amplified by respective main and auxiliary amplifier, the signals are recombined at the power combiner node. Both the main and the auxiliary amplifier operate when the input signal is high, and are each presented with the load impedance that enables maximum power output. However, as the power of the input signal decrease the auxiliary amplifier is turned off and only the main amplifier is in operation. At these lower power levels, the main amplifier is presented with a modulated load impedance that enables higher efficiency and gain. The result is an extremely efficient solution for amplifying the complex modulation schemes employed e.g. in wireless systems.

According to the present disclosure the same basis principle as used in Doherty amplifiers are used in order to solve or at least alleviate the previously disclosed problems.

Depending on if the splitting operation at the power splitter node generates a phase offset the phase offset of concerned signal may have to be compensated for by using a matching element to restore the phase offset. Thus, according to an aspect of the present disclosure, which is valid and can be combined with all aspects of the present disclosure disclosed herein, the main power amplifying circuit and/or the auxiliary power amplifier circuit, man comprise at least one matching element provided for restoring possible phase offset created by the power splitter node.

Further, the configuration, thus the splitting of the input power into the main and auxiliary power amplifier circuit, of the splitter node is dependent on the gain of the main amplifier and the gain of the auxiliary amplifier such that a desired output power, in regards to the provided input power, is obtained. Or, differently expressed, the configuration of the splitter node is dependent on the gain of the main amplifier and the gain of the auxiliary amplifier, such that a desired power increase of the input power is obtained as output power.

To give an example of when such amplifying circuitry is used for power increase of an incoming (transmission) signal with a certain input power;

For an amplifying circuitry where the input power is 11 W and the desired output power is 500 W, and the amplifying circuitry comprises a main power amplifier with a gain of 20 dB and an auxiliary power amplifier with a gain of 16 dB, the splitting needs to be 1 to 10, wherein 1 W (first amplifier signal) is routed through the main power amplifying circuit comprising the main amplifier and 10 W (second amplifier signal) is routed through the auxiliary power amplifying circuit comprising the auxiliary amplifier.

Main power amplifying circuit: 1 W input power = 30 dBm, + 20 dB power increase from main amplifier = 50 dBm = 100 W.

Auxiliary power amplifying circuit: 10 W input power = 40 dBm, + 16 dB power increase from auxiliary amplifier = 56 dBm = 400 W.

$$100 \text{ W} + 400 \text{ W} = 500 \text{ W}$$

To give a further example of when such amplifying circuitry is used for power increase of an incoming (transmission) signal with a certain input power;

For an amplifying circuitry where the input power is 20 W and the desired output power also is 500 W, and the amplifying circuitry comprises a main amplifier with a gain of 10 dB and an auxiliary amplifier with a gain of 16 dB, the splitting needs to be 1 to 1, wherein 10 W (first amplifier signal) is routed through the main power amplifying circuit comprising the main amplifier and 10 W (second amplifier signal) is routed through the auxiliary power amplifying circuit comprising the auxiliary amplifier.

Main power amplifying circuit: 10 W input power = 40 dBm, + 10 dB power increase from main amplifier = 50 dBm = 100 W.

Auxiliary power amplifying circuit: 10 W input power = 40 dBm, + 16 dB power increase from auxiliary amplifier = 56 dBm = 400 W.

$$100 \text{ W} + 400 \text{ W} = 500 \text{ W}$$

The gain of the main amplifier is selected to give desired output power, in respect to the input power, in backed off mode. The power splitter node, meaning power splitting properties of the power splitter node, is configured to give the desired output power in peak operation mode and is dependent on the input power and the gain of the main and auxiliary power amplifiers. Thus, the power splitter node and the auxiliary power amplifier have to be configured interdependent and dependently on the input power, the gain of the main power amplifier and the desired output power.

The present disclosure provides an electronically scanned antenna system providing identification functionality which is configured to manage up to a doubling of the transmission amplitude, thus up to a 6 dB increase of the transmission power, for the antenna elements where the sum interrogation signal and the delta interrogation signal are transmitted simultaneously. The antenna system of the present disclosure manages the 6 dB increase in transmission power without having to use switches in order to connect and/or disconnect amplifiers. The use of switches is not only problematic due to that the response time of such switches may not be sufficiently short, but also due to that the switches have to be able to manage sufficiently high power levels.

When the antenna system not is operating in mode S, thus when no additional transmission power is required from the auxiliary power amplifying circuit, only the main power amplifying circuit is used. When the auxiliary power amplifier circuit is used may e.g. be controlled by a bias controller. This will be discussed more in detail later.

According to one aspect of the present disclosure the transmit-receive module comprises two signal transferring means, a transmission line and a reception line, wherein the signal transferring means provides the functionality of either directing an incoming transmission signal fed from the 180-degree hybrid through the transmission line to the antenna structure or directing a received reply signal from the antenna structure through the reception line and to the 180-degree hybrid, from which the reply signal may be fed to the transceiver module.

The transceiver may comprise components such as a receiver, for demodulating received RF signals, and a processing unit, for demodulating signals from the receiver and decoding the response received or other components providing essentially the same functionality. The signal transferring means may be in form of a circulator, a switch or another component with at least the functionality to direct incoming signals.

According to another aspect of the present disclosure the transmit-receive module comprises at least one phase shifting unit. The phase shifting unit is configured to control the phase of respective transmission signal. The direction of an antenna main lobe of an antenna is dependent on the phase of the transmission signal, wherein by controlling the phase the direction of the main lobe can be controlled. This is, as previously has been disclosed, the fundamental principle for electrically scanned arrays. Respective phase shifting unit is configured to be connected to the antenna system between the signal processing means, e.g. in form of a 180-degree hybrid, and respective amplifying circuitry. Preferably the phase shifter is arranged before the transmission power is amplified by the power amplifying circuitry since conventional phase shifter not are configured for that high power levels. In order to obtain good controllability of the resulting antenna beam lobes it is preferred that all antenna elements are provided with one individual phase shifter.

According to one aspect of the present disclosure the transmission line and the receive line comprises one phase shifter each. For such aspect of the present disclosure the phase shifter of the transmission line provides the functionality of controlling the direction of the main lobe of the antenna, by controlling the phase of the transmission signal, and the phase shifter of the reception line allows the received reply signals over the sum and delta channels to be set in phase for subsequent processing and decoding.

Except for possibly comprising a phase shifter and circulators and/or switches the reception line may also comprise additional components such as e.g. low noise amplifiers and band pass filters.

According to yet another aspect of the present disclosure the amplifying circuitry comprises a bias controller. The bias controller is configured to control the functionality of the amplifying circuitry, wherein when no power increase is required, such as when the sum and delta interrogation signals are not transmitted simultaneously, the bias controller may be used to disable the auxiliary power amplifier.

As previously stated the main power amplifier circuit comprises a main amplifier and the auxiliary power amplifier circuit comprises an auxiliary amplifier. The main power amplifier circuit and the auxiliary power amplifier circuit, and respective main and auxiliary amplifier, are part of the amplifying circuitry, wherein the amplifying circuitry also comprises a power splitter node and a power combiner node. The auxiliary power amplifier circuit is configured such that when both the main power amplifier circuit and the auxiliary power amplifier circuit are used, the output power may be essentially four times the power then if only the main amplifier is used. This is referred to as operation in peak operation mode. Consequently, when operating in a backed-off mode (referred to as backed-off operation mode), where only the main amplifier of the main power amplifier circuit, is used, the output power is backed off essentially 6 dB. A fourfold increase in output power corresponds to a doubling of the transmission amplitude, which is what is required in order to be able to transmit the sum and delta interrogation signals simultaneously. The output power is dependent on the gain of respective amplifier and the split of the incoming signal at the splitting node in accordance to what previously has been discussed.

The amplifying circuitry may be either symmetric or asymmetric, wherein in a symmetric amplifying circuitry both the main and the auxiliary amplifier are either linear or nonlinear whereas in an asymmetric amplifying circuitry the main and auxiliary amplifiers or of different type. The difference between linear and nonlinear amplifiers, the technical features of respective type of amplifier and the advantages and disadvantages of respective type of amplifier is considered to be known and is not part of the present disclosure per se. Thus, the functionality of linear and nonlinear amplifiers will not be further discussed herein.

Below a few exemplifying configurations of main and auxiliary amplifiers are disclosed:
According to a first aspect of the present disclosure the main amplifier is a linear amplifier and the auxiliary amplifier is a nonlinear amplifier, wherein an output power of the main amplifier is a linear representation of the input power, and an output power of the auxiliary amplifier is a nonlinear representation of the input power.

According to a second aspect of the present disclosure the main amplifier and the auxiliary amplifier are nonlinear amplifiers, wherein an output power of the main amplifier is a nonlinear representation of the input power, and an output power of the auxiliary amplifier is a nonlinear representation of the input power.

According to another aspect of the present disclosure the output power of the main amplifier and the output power of the first auxiliary amplifier are dimensioned for equal power output. According to this aspect the main amplifier is a linear amplifier, and is operating at 3dB below saturation mode when operating in the backed-off operation mode, and the auxiliary amplifier is a nonlinear amplifier. When transmitting in mode S both the main and the auxiliary amplifier is operating in saturation mode, providing an output power increase of 6 dB.

According to yet another aspect of the present disclosure the output power of the auxiliary amplifier is essentially 5 dB higher than the output power of the main amplifier, such that when the main amplifier and the auxiliary amplifiers are operating at their respective highest output power the resulting output power is essentially 6 dB higher than if only the main amplifier is operated at its highest output power. According to this aspect both the main and the auxiliary amplifier are nonlinear amplifiers, and the main amplifier is operating at saturation mode, at which the amplifier is working at maximum efficiency, both when operating in the backed off operation mode and in peak operation mode. When operating in peak operation mode, such as when transmitting in mode S, also the auxiliary amplifier with a 5 dB higher output power than the main auxiliary amplifier is operating in saturation mode giving a 6 dB power increase all together.

The aspect of the present disclosure where both the main and the auxiliary amplifiers are nonlinear amplifier, and where they both are operating at saturation mode when operating in peak operation mode, is more efficient than the aspect of the present disclosure with two amplifiers dimensioned for the same power output. According to the latter aspect the main amplifier is a linear amplifier operating at 3 dB below saturation the predominant part of the time. When operating at 3 dB below saturation mode the efficiency of the amplifier is lower than when operating at saturation mode.

Below an exemplary realization of an antenna system according to the present disclosure is disclosed.

As has been disclosed previously, the relation between the absolute output power values in watts, W, and dBm is expressed by:

$$P(dBm) = 10*log(P(mW)/1(mW)])  \qquad (1)$$

where

P(dBm) is the absolute transmission power expressed in dBm, and
P(mW) is the absolute transmission power expressed in milliwatts, mW.

Thus,
25 W = 44 dBm,
75 W = 49 dBm and
100 W = 50 dBm.

(It should be noted that the above stated number values are approximate, rounded off values which are used to explain the fundamental principles. They are not bee seen as limiting in anyway.)

According to one example of the present disclosure, wherein an identification system with a general operation power of the antenna system of 25 W is considered, the amplifying circuitry of the antenna system may comprise a nonlinear main 25 W amplifier with an absolute output power of 44 dBm and a nonlinear auxiliary 75 W amplifier with a 5 dB higher output power than the main amplifier, thus with an absolute output power of 49 dBm. When such an amplifying circuitry is operating in a backed-off operation mode only the main amplifier is in operation, providing an output power of 25 W when operating in saturation mode. Thus, during operation in backed-off operation mode the nonlinear main amplifier is operated in saturation mode at a high operating efficiency.

As previously stated, in peak operation mode, such as when operating in mode S where a sum interrogation signal and a delta interrogation signal is transmitted essentially simultaneously, the transmission amplitude may be up to essentially doubled for one half of the antenna (and may be, at least partly, cancelled out for the other part of the antenna). A doubling of the transmission amplitude corresponds to a fourfold increase in transmission power, which in this case would be an increase to 100 W output power. (Note: 100 W correspond to 50 dBm, thus 6 dB higher than for 25 W.) The 100 W is provided by operating both the auxiliary amplifier of 75 W and the main amplifier of 25 W. When the auxiliary amplifier provides an output power of 75 W and the main amplifier provides an output power of 25 W they are both operating in saturation mode, thus at their respective maximum operating efficiency.

Further, the present disclosure relates to a method for using the identification system disclosed in any of, or a combination of, the above disclosed aspects of the present disclosure.

According to one aspect of the present disclosure a method of transmitting an interrogation signal by using an aspect, or a combination of aspects, of antenna system disclosed herein comprises the method steps of:

- generating a sum interrogation signal and a delta interrogation signal, wherein the generating of signals is performed in a transceiver module,
- feeding the sum interrogation signal and the delta interrogation signal to a signal processing means, wherein the sum and delta interrogation signals are feed in phase, and wherein the signal processing means is
  ◦ combining the sum and delta channel interrogation signals to transmission signals with different phase to different halves of the antenna,
- feeding the transmission signals to at least two transmit-receive modules, wherein respective transmit-receive module is at least performing:

    ◦ phase shifting of the transmission signal, wherein the phase shifting is performed by a phase shifter and wherein by the phase shifting the direction of a resulting antenna main lobe is controllable,
    ◦ amplifying of the transmission signal, wherein the power increase of the transmission signal is performed in an amplifying circuitry comprising a power splitter node, a main amplifier of a main power amplifying circuitry, an auxiliary amplifier of an auxiliary power amplifying circuitry and a power combiner node,

- transmitting the amplified transmission signals, wherein the transmission signals are transmitted by antenna structures, wherein each antenna structure comprises at least one antenna element.

The present disclosure also relates to an active electrically steerable antenna comprising a primary antenna system and an antenna system according to any one, or a combination of, the aspects of the disclosure disclosed herein, and an air, sea or ground based unit comprising such active electrically steerable antenna.

Aspects, or combination of aspects, of the present disclosure may also advantageously be used in other transmitting situations where e.g. a sum and a delta channel interrogation signal, or other signals, are transmitted simultaneously or overlapping such that it is desirable that the transmitting amplitude is up to doubled in relation to operation in backed-off operation mode.

According to aspects of the present disclosure at least one circulator, or other device providing similar functionality such as e.g. a switch, is provided between the transmitter and the antenna and the antenna and the receiver such that signals from the transmitter may be routed towards the antenna and signals received by the antenna may be routed towards the receiver.

According to further aspects of the present disclosure the amplifying circuitry may also comprise at least a second auxiliary power amplifying circuit arranged in parallel to the main and (first) power amplifier circuits. Such amplifying circuit may comprise a second auxiliary amplifier. For such aspects the power splitter node and the power combiner node are configured to split up the input power and combine the output power respectively for at least three amplifying circuits. Depending on the desired properties of the amplifying circuitry, and the configuration of the main amplifier and the (first) auxiliary amplifier, the second auxiliary amplifier may be either linear or nonlinear. Also the output of the second amplifier may be configured according to the main and (first) auxiliary amplifier. It is also possible to arrange even more than three power amplifying circuits with further auxiliary amplifiers in parallel.

As is apparent for a person skilled in the art the system of the present disclosure may additionally comprise other commonly used and generally known radar components such as duplexers, low or high band pass filters etc.

According to yet aspects of the present disclosure, the present disclosure comprises:

a computer program comprising program code means for performing the steps of any of, or a combination of, the methods when said program is run on a computer or like,

a computer readable medium carrying a computer program comprising program code means for performing the steps of the methods when said program is run on a computer or like and

a control unit for controlling the antenna system according to any of the disclosed aspects of the present disclosure, wherein the control unit is being configured to perform the steps of the methods.

Further advantages and advantageous features of the disclosure are disclosed in the following description and in the dependent claims.

BRIEF DESCRIPTION OF THE DRAWINGS

With reference to the appended drawings, below follows a more detailed description of exemplary embodiments of the present disclosure.

Fig. 1 shows a schematic view of a vehicle mounted radar system,

Fig. 2 discloses a first embodiment of an identification system,

Fig. 3 discloses a second embodiment of an identification system, and

Fig. 4 discloses a third embodiment of an identification system.

DETAILED DESCRIPTION OF EXAMPLE EMBODIMENTS OF THE INVENTION

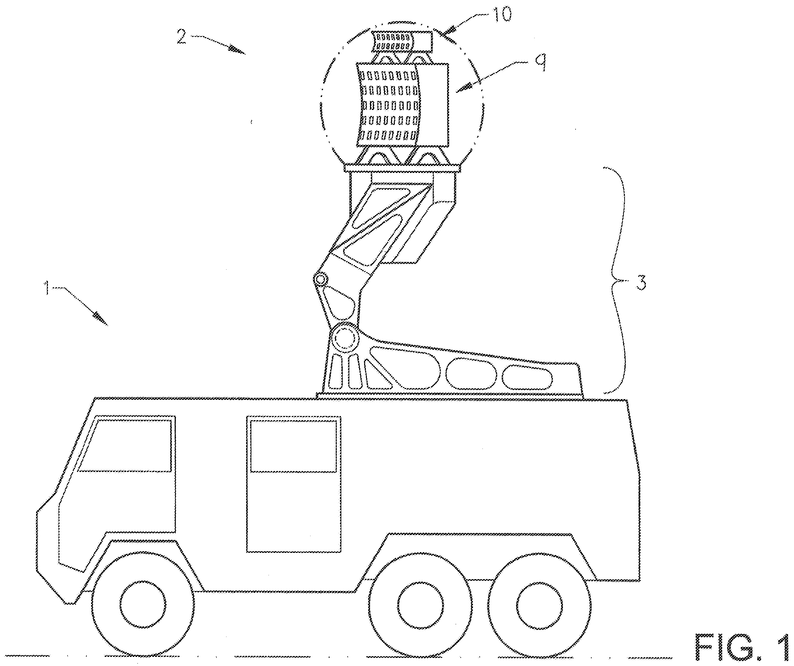

Fig. 1 shows an example of an implementation of an antenna system 10 of the present disclosure. Fig. 1 shows a terrain vehicle 1 provided with an electrically steerable antenna 2, wherein the active electrically steerable antenna 2 is mounted to the vehicle 1 by means of an extendable arm structure 3. The active electrically steerable antenna 2 comprises a primary radar system 9 and the antenna system 10 according to the present disclosure. The antenna system 10 may be a secondary radar system providing identification functionality.

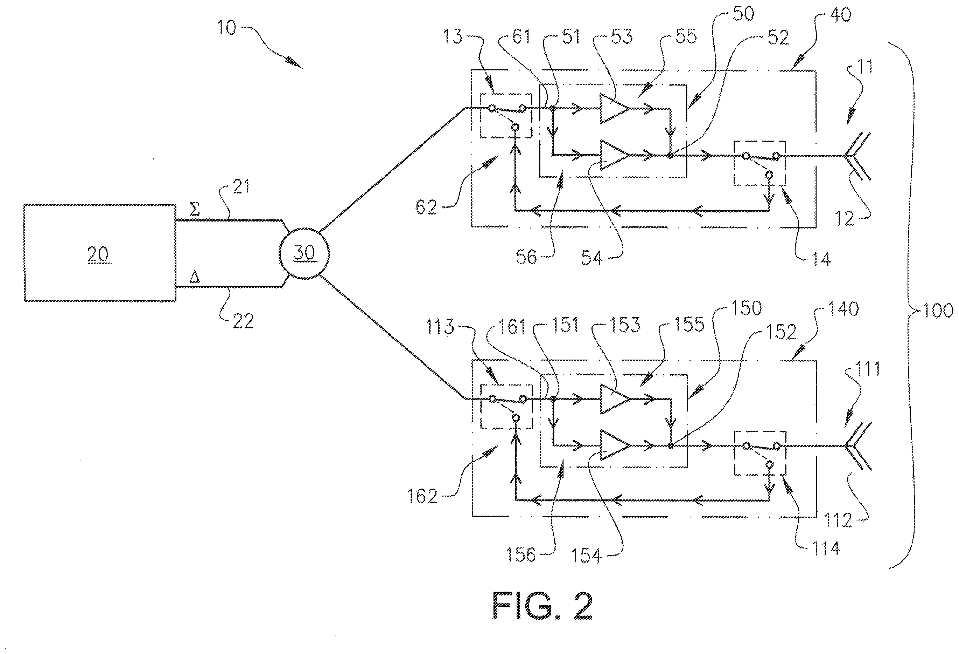

Fig. 2 discloses a simplified, first embodiment of an antenna system 10 comprising an antenna 100 according to the present disclosure. The antenna system 10 comprises a transceiver module 20, a signal processing means 30, a first and a second transmit-receive module 40, 140 and a first and a second schematically shown antenna structure 11, 111. The transceiver module 20 comprises at least means for generating a sum interrogation signal, which is fed to the signal processing means 30 via a sum interrogation signal channel 21, and a delta interrogation signal, which is fed to the signal processing means 30 via a delta interrogation signal channel 22. Sum channel interrogation signals are provided via a sum port and delta, or difference, channel interrogation signals are provided via a delta, or difference, port. Further, the transceiver module 20 may comprise processing means for decoding and analysing received reply signals. The signal processing means 30 has the functionality of adding and subtracting incoming signals for the two halves of the antenna, and may e.g. be in form of a 180-degree hybrid. The functionality of a 180-degree hybrid is not part of the disclosure per se and is considered to be part of general knowledge.

To give an example;

At transmission; Sum channel interrogation signals, i.e. signals in the sum port, will be divided in to two equal amplitude and phase signals provided to the two antenna halves by a signal processing means, such as a 180-degree hybrid. Delta channel interrogation signals, i.e. signals in the delta or difference port, will be divided in to two equal amplitude and essentially 180 degrees out of phase signals in the two antenna halves by a signal processing means, such as a 180-degree hybrid.

The antenna 100 comprises the antenna structures 11, 111, in turn comprising at least one antenna element 12, 112 each. Please note that the antenna structures 11, 111 and the antenna elements 12, 112 are only schematically disclosed in fig. 2. At least two antenna structures 11, 111 are needed in order to form the two operating halves of the antenna 100. Respective first and second transmit-receive module 40, 140 comprises a first and a second amplifying circuitry 50, 150. Respective first and second amplifying circuitry 50, 150 comprise a power splitter node 51, 151, a main power amplifying circuit 55, 155 wherein the main power amplifying circuit 55, 155 comprises at least a main amplifier 53, 153, an auxiliary power amplifying circuit 56, 156, wherein the auxiliary power amplifying circuit 56, 156 comprises at least an auxiliary amplifier 54, 154 and a power combiner node 52, 152. Respective main power amplifying circuit 55, 155 and respective auxiliary power amplifying circuit 56, 156 are arranged in parallel between respective power splitter node 51, 151 and respective power combiner node 52, 152. Respective amplifying circuitry 50, 150 is provided in a transmission line 61, 161 and in parallel to respective transmission line 61, 161 a reception line 62, 162 is provided. The guiding of transmission signals and received reply signals in respective line is controlled by a first and a second signal transferring means 13, 113, 14, 114. In the embodiment of fig. 2 the first and second signal transferring means 13, 113, 14, 114 are schematically disclosed as a switch simply redirecting the transmission signal from the signal processing means 30 via the transmission line 61, 161 to the antenna structure 11, 111, or the received reply signal from the antenna structure 11, 111 via the reception line 62, 162 to the signal processing means 30, but respective first and second signal transferring means 13, 113, 14, 114 may also comprise other functionalities. In one very simplified embodiment respective signal transferring means 13, 113, 14, 114 may be in form of a circulator.

In the embodiment of fig. 2 the antenna structures 11, 111 are used both for transmission and reception, wherein the signal transferring means 14 provides the functionality of either directing a transmission signal from the transmission line 61, 161 to the antenna structure 11, 111 or directing an received reply signal from the antenna structure 11, 111 to the reception line 62, 162. Even if not disclosed in fig. 2, it is also possible to use separate antenna structures for transmitting signals and for receiving reply signals in order to provide the transmitting and receiving functionality. The two alternatives of providing transmitting and receiving functionality, with the respective advantages and drawbacks of respective alternative, are considered to be part of common general knowledge and are not further discussed herein.

An identification antenna system used for identification of e.g. aircrafts operating in mode S occasionally transmits the sum interrogation signal and the delta interrogation signal simultaneously. Depending on the phase of respective sum and delta signal this may imply that the transmission amplitude becomes up to twice as high in one half of the antenna and is cancelled out in one half of the antenna. This is referred to as the peak amplitude. When transmitting with the peak amplitude essentially 6 dB higher transmission power is required. This is referred to as the peak transmission power. Operation in this mode is referred to as peak operation mode.

As previously stated, in antenna systems where the amplitude of the signal modulation is constant, nonlinear amplifiers are preferably used. A nonlinear power amplifier is most efficient when operating in a mode referred to as saturation mode. and the amplifier is preferably selected such that the amplifier is operating in such saturation mode during backed-off operation. When an identification antenna system is operating in mode S, wherein the sum channel signal and the delta channel signal are transmitted simultaneously, wherein in one half of the antenna the amplitude of the resulting signal may be essentially twice as high than if only one of the sum interrogation signal or the delta interrogation signal would have been transmitted. Thus, the amplifier of an identification system operating in mode S must be designed to manage transmission at up to 6 dB higher transmission power than needed when only either a sum interrogation signal or a delta interrogation signal is transmitted.

If a linear amplifier configured for 6 dB power increase is used the efficiency would be low since the efficiency of linear amplifiers, such as amplifiers of A, B or AB type, operating in backed off mode generally are quite low. If instead a nonlinear amplifier, such as a class C amplifier, configured for the peak amplitude, is selected the efficiency would be high when operating in saturation mode but the average efficiency would be lower since the amplifier would only operate in saturation mode during the very limited time operating in peak operation mode. Thus, neither a linear nor a nonlinear amplifier configured for 6 dB power increase would be an efficient way to solve the mode S higher transmission power requirement.

According to the present disclosure there are two ways in which the main amplifiers 53, 153 and auxiliary amplifiers 54, 154 may be selected.

According to a first aspect of the present disclosure the main amplifier 53, 153 is preferably selected to be a linear amplifier and the auxiliary amplifier 54, 154 is preferably a nonlinear amplifier. The main amplifier 53, 153 is preferably selected to operate 3 dB backed-off from saturation mode during backed-off operation. The main amplifier 53, 153 and the auxiliary amplifier 54, 154 are also preferably dimensioned for the same maximal output power.

According to a second aspect of the present disclosure both the main amplifier 53, 153 and the auxiliary amplifier 54, 151 are preferably nonlinear amplifiers. The main amplifier 53, 153 are preferably dimensioned to work at saturation mode during backed-off operation conditions of the antenna and the auxiliary amplifier 54, 154 is preferably configured to have a 5 dB higher output such that in peak operation mode, when also the auxiliary amplifier 54, 154 is in use, totally 6 dB high output is delivered. The second aspect of the present disclosure is particularly advantageous since the amplifiers 53, 54, 153, 154 work at saturation mode both at back-off operation mode and in peak operation mode.

By using the amplifying circuitry 50, 150 as according to the present disclosure the antenna system 10 of the present disclosure may operate in mode S with maintained efficiency.

In the simplified embodiment of the present disclosure shown in fig. 2 the antenna system 10 comprises two antenna structures 11, 111 with one antenna element 12, 112 each. This embodiment should not be seen as limiting. According to other embodiments, of which a few examples will be shown in the figures described below, more than two antenna structures may be present as well as more than one antenna element per antenna structure, i.e. that the antenna structure forms an array of antenna elements.

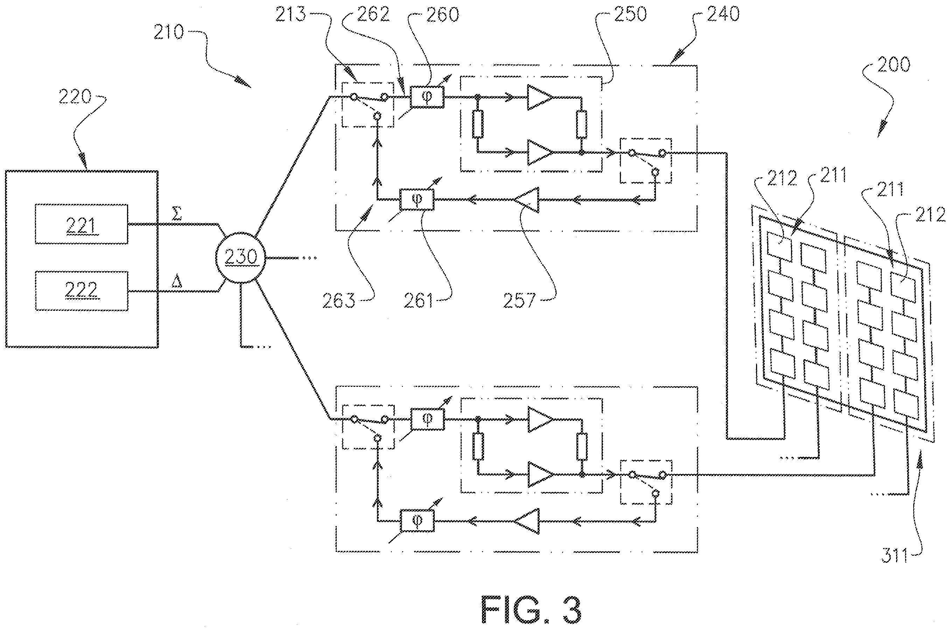

Fig. 3 discloses a second embodiment of an antenna system 210 showing, in addition to what is shown in the embodiment shown in fig. 2, additional components and features that may be present according to the present disclosure.

In addition to what is disclosed in fig. 2 the embodiment of fig. 3 shows a number of optional features, which depending on the configuration of the antenna system 210 may be advantageous. In the exemplary embodiment of fig. 3 a transceiver 220 is disclosed, wherein the transceiver 220 comprises a first and a second processing unit 221, 222. The first processing unit 221 is configured for generating sum interrogation signals and the second processing unit 222 is configured for generating delta interrogation signals. The transceiver 220 is also configured for decoding and analysing received reply signals. How said signals are generated and subsequently processed is not part of the disclosure per se and is considered to be part of common general knowledge.

Fig, 3 further discloses a signal processing means 230, which e.g. may be in form of a 180-degree hybrid.

By controlling the phase of the transmission signals the direction of the resulting antenna main lobe may be controlled. To control the direction of the antenna main lobe by controlling the phase is the fundamental principle behind electrically steerable antennas. In the embodiment of fig. 3 the transmit-receive modules 240 are provided with a first and a second phase shifter 260, 261. A transmission line 262 is provided with the first phase shifter 260 controlling the phase of the transmission signal and the reception line 263 is provided with the second phase shifter 261 controlling the phase of the received reply signal. It is desirable that the reception direction is adjusted according to the direction of the reply signal such that the reply signal can be received at maximum signal strength.

Thus, by controlling the phase of the transmitted signal the direction of the main lobe of the identification antenna can be controlled, and by controlling the reception phase with the second phase shifter 261 the reply signal can be received at maximum signal strength from the main lobe.

In the simplified embodiment of the present disclosure shown in fig. 2 the transmission line 262 and the reception line 263 comprises a phase shifter 260, 261 each. As is apparent for a person skilled in the art, the present disclosure may also be practiced using just use one phase shifter for each transmit-receive module 240, wherein the phase sifter in such case is arranged between a signal transferring means 213 and the signal processing means 230 such that the same phase shifter may be used both for signals to be transmitted and received signals.

Further, in the embodiment disclosed in Fig. 3 a low noise amplifier (LNA) 257 is arranged in respective reception line 263 in order to amplify respective reception signal such that circuitry efficiency losses becomes less critical.

Also, in the embodiment shown in fig. 3 the antenna structures 211, 311 are in from of an array antenna 200. The array antenna 200 comprises a first antenna structure 211 and a second antenna structure 311. Further, in the embodiment shown in fig. 3 respective antenna structure 211, 311 are in form of two parallel rows of interconnected antenna elements 212.

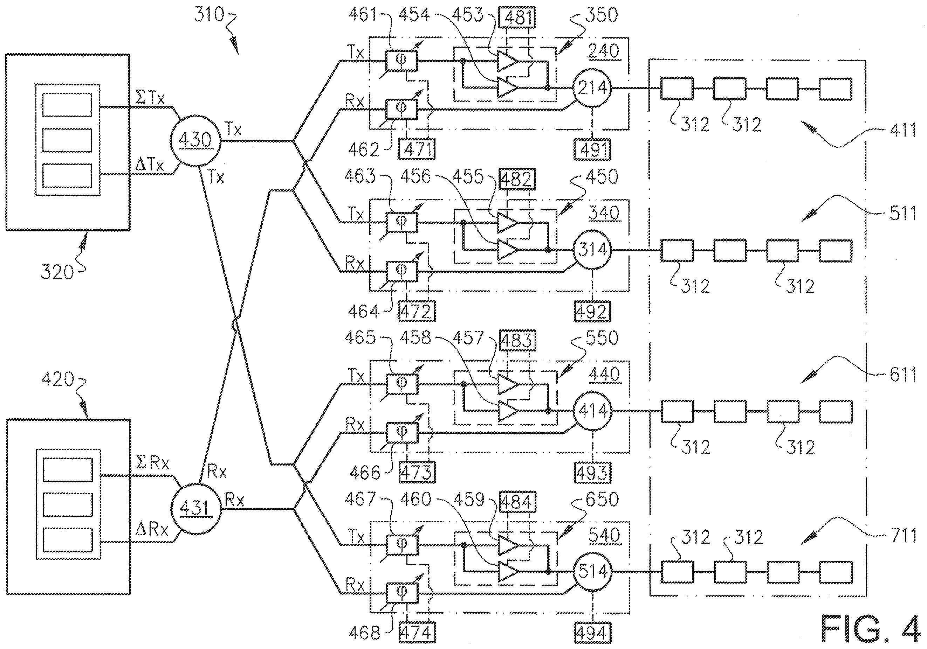

Fig. 4 discloses a third embodiment of an antenna system 310. The antenna system 310 of fig. 4 corresponds in many aspects to the embodiments of antenna systems 10, 210 disclosed in fig. 2 and 3, but e.g. with the exception that the embodiment of fig. 4 discloses a first transceiver module 320 generating sum and delta interrogation signals, that subsequently will be transmitted, and a second transceiver module 420 for processing received reply signals.

The generated sum and delta interrogation signals are processed by a first signal processing means 430 and fed to reception lines of transmit-receive modules 240, 340, 440, 540 via transmission paths Tx to antenna structures 411, 511, 611, 711 for transmission, and the receives reply signals are fed via reception lines of transmit-receive modules 240, 340, 440, 540 and via reception paths Rx to a second signal processing means 431 before being processed at the second transceiver module 420. The first and second signal processing means 430, 431 may e.g. be in form of 180-degree hybrids.

Further, in fig.4 a number of controllers 471-474, 481-484, 491-494 are exemplified. Phase shifter controllers 471-474 are provided to control the phase shifters 461-468 of the transmit-receive modules 240, 340, 440, 540, amplifier controllers 481-484 are provided to control the functionality of main and auxiliary amplifiers 453-460 and signal transferring means controllers 491-494 are provided to control the functionality of signal transferring means 214, 314, 414, 514. The transmit-receive modules 240, 340, 440, 540 including its components such as phase shifters 461-468, main and auxiliary amplifiers 453-460 provides the same functionality as previously described in relation to fig. 2 and fig. 3. E.g. the signal transferring means 214, 314, 414, 514 provide the functionality of either directing transmission signals generated by the first transceiver module 320 to antenna structures 411, 511, 611, 711 or directing received reply signals from the antenna structures 411, 511, 611, 711 to the second transceiver module 420.

The antenna four structures 411, 511, 611, 711 of the embodiment of fig. 4 comprise four antenna elements 312 each.

It is to be understood that the present disclosure is not limited to the embodiments described above and illustrated in the drawings; rather, the skilled person will recognize that many changes and modifications may be made within the scope of the appended claims.

**Claims**

1.  An antenna system (10) for providing identification functionality comprising:

    • two antenna structures (11, 111), wherein each antenna structure (11, 111) comprises at least one antenna element (12, 112),
    • a transceiver module (20) configured to generate a sum interrogation signal and a delta interrogation signal,
    • a signal processing means (30), wherein the signal processing means (30) is configured to process provided sum and delta interrogation signals into transmission signals,
    • at least two transmit-receive modules (40, 140), wherein each of the transmit-receive modules (40, 140) is configured to transmit a transmission signal provided by the signal processing means (30) by means of a respective one of the antenna structures (11,111),

    wherein when in operation the transceiver module (20) is connected to the signal processing means (30), the signal processing means (30) is connected to the transmit-receive modules (40, 140), and the transmit-receive modules (40,140) are connected to the antenna structures (11, 111), and wherein each transmit-receive module (40, 140) is provided with an amplifying circuitry (50, 150), the antenna system (10) being **characterized in that** each amplifying circuitry (50, 150) comprises:

    a splitter node (51, 151), wherein the splitter node (51, 151) is configured to split the transmission signal in at least a first and a second amplifier signal,
    a main power amplifier circuit (55, 155), wherein the main power amplifier circuit (55, 155) comprises a main amplifier (53, 153), wherein the main amplifier (53, 153) is configured to amplify the first amplifier signal,
    an auxiliary power amplifier circuit (56, 156), wherein the auxiliary power amplifier circuit (56, 156) comprises an auxiliary amplifier (54, 154), wherein the auxiliary amplifier (54, 154) is configured to amplify the second amplifier signal, and
    a power combiner node (52, 152), wherein the power combiner node (52, 152) is configured to combine the first and the second amplifier signal of the main power amplifier circuit (55, 155) and of the auxiliary power amplifier circuit (56, 156), and wherein
    the main power amplifier circuit (55, 155) and the auxiliary power amplifier circuit (56, 156) are provided in parallel between the power splitter node (51, 151) and the power combiner node (52, 152).

2.  An antenna system (210) according claim 1, wherein each transmit-receive module (240) comprises at least one phase shifting unit (260), wherein the phase shifting unit (260) is configured to control the phase of respective transmission signal, wherein the direction of antenna main lobes of respective antenna structure (211) is dependent on the phase of respective transmission signal, and wherein the phase shifting unit (260) is configured to be connected to the antenna system (210) between the signal processing means (230) and the amplifying circuitry (250).

3.  An antenna system (310) according to any of the preceding claims, wherein the amplifying circuitry (350,450,550,650) additionally comprises a bias controller (481,482,483,484), wherein the bias controller (481,482,483,484) is configured to control the functionality of the main and auxiliary amplifiers (453,455,457,459;454,456,458,460).

4.  An antenna system (10) according to any of claims 1 to 3, wherein an output power of the main amplifier (53, 153) is a linear representation of the input power, and an output power of the first auxiliary amplifier (54, 154) is a nonlinear representation of the input power.

5.  An antenna system (10) according to any of claims 1 to 3, wherein an output power of the main amplifier (53, 153) is a nonlinear representation of the input power, and an output power of the first auxiliary amplifier (54, 154) is a nonlinear representation of the input power.

6.  An antenna system (10) according to any of claim 1 to 5, wherein the output power of the main amplifier (53, 153) and the output power of the first auxiliary amplifier (54, 154) are dimensioned for essentially equal power output.

7.  An antenna system (10) according to any of claim 1 to 5, wherein the output power of the auxiliary amplifier (54, 154) is essentially 5 dB higher than the output power of the main amplifier (53, 153), such that when the main amplifier (53, 153) and the auxiliary amplifiers (54, 154) are operating at their respective highest output power the resulting output power is essentially 6 dB higher than if only the main amplifier (53, 153) is operated at its highest output power.

8. An antenna system (10) according to any of claim 1 to 7, wherein the signal processing means (30) is in form of a 180-degree hybrid.

9. An active electrically steerable antenna (2) comprising a primary antenna system and an antenna system (10, 210, 310) according to any of claims 1 to 8.

10. An air, sea or ground based unit (1) comprising the active electrically steerable antenna according to claim 9.

11. A method of transmitting an interrogation signal by using an antenna system (210) according to any of the claim 1 to 8, comprising the method steps of:

 • generating a sum interrogation signal and a delta interrogation signal, wherein the generating of signals is performed in a transceiver module (220)
 • feeding the sum interrogation signal and the delta interrogation signal to a signal processing means (230), wherein the signal processing means (230) is
 ∘ combining the sum and delta channel interrogation signals to transmission signals,
 • feeding the transmission signals to at least two transmit-receive modules (240), wherein respective transmit-receive module (240) at least is performing:
 ∘ amplifying of the respective transmission signal, wherein the power increase of the transmission signal is performed in an amplifying circuitry (240) comprising a power splitter node (251), a main amplifier (253) of a main power amplifying circuitry (255), an auxiliary amplifier (254) of an auxiliary power amplifying circuitry (256) and a power combiner node (252),
 • transmitting the amplified transmission signals, wherein the transmission signals are transmitted by antenna structures (211), wherein each antenna structure (211) comprises at least one antenna element (212).

12. A method of transmitting an interrogation signal according to claim 9, wherein respective transmit-receive module (240) comprises at least one phase shifting unit (260), wherein said phase shifting unit (260) is configured to control the phase of signals to be transmitted and/or received signals, and wherein the method further comprises the method step of:

 • phase shifting of the transmission signal,

wherein by the phase shifting of the transmission signal the direction of an antenna main lobe is controllable.

13. A control unit for controlling the antenna system of any of claims 1 to 8, wherein the control unit is being configured to perform the steps of the method according to any of claims 11 or 12.

14. A computer program comprising program code means for performing the steps of the method according to any of claims 11 or 12 when said program is run on a computer connected to the antenna system of any of claims 1 to 8.

15. A computer readable medium carrying a computer program according to claim 14.

**Patentansprüche**

1. Antennensystem (10) zur Bereitstellung von Identifizierungsfunktionalität umfassend:

 • zwei Antennenstrukturen (11, 111), wobei jede Antennenstruktur (11, 111) mindestens ein Antennenelement (12, 112) umfasst,
 • ein Sender/Empfänger-Modul (20), das zur Erzeugung eines Summenabfragesignals und eines Deltaabfragesignals ausgelegt ist,
 • ein Signalverarbeitungsmittel (30), wobei das Signalverarbeitungsmittel (30) dafür ausgelegt ist, das bereitgestellte Summenabfragesignal und Deltaabfragesignal zu Übertragungssignalen zu verarbeiten,
 • mindestens zwei Sende-/Empfang-Module (40, 140), wobei jedes der Sende-/Empfang-Module (40, 140) dafür ausgelegt ist, ein Übertragungssignal zu übertragen, welches durch das Signalverarbeitungsmittel (30) mittels einer jeweiligen der Antennenstrukturen (11, 111) bereitgestellt wird,

wobei das Sender/Empfänger-Modul (20) in Betreib mit dem Signalverarbeitungsmittel (30) verbunden ist, das Signalverarbeitungsmittel (30) mit den Sende-Empfang-Modulen (40, 140) verbunden ist, und die Sende-Empfang-Module (40,140) mit den Antennenstrukturen (11, 111) verbunden sind, und wobei jedes Sende-Empfang-Modul (40, 140) mit einer verstärkenden Schaltung (50, 150) vorgesehen ist, wobei das Antennensystem (10) **dadurch gekennzeichnet ist, dass** jede
verstärkende Schaltung (50, 150) Folgendes umfasst:

einen Splitterknoten (51, 151), wobei der Splitterknoten (51, 151) dafür ausgelegt ist, das Übertragungssignal in mindestens ein erstes und ein zweites Verstärkersignal zu teilen,
eine Hauptleistung-Verstärkerschaltung (55, 155), wobei die Hauptleistung-Verstärkerschaltung (55, 155) einen Hauptverstärker (53, 153) umfasst, wobei der Hauptverstärker (53, 153) dafür ausgelegt ist, das erste Verstärkersignal zu verstärken, eine Hilfsleistung-Verstärkerschaltung (56, 156), wobei die Hilfsleistung-Verstärkerschaltung (56, 156) einen Hilfsverstärker (54, 154) umfasst, wobei der Hilfsverstärker (54, 154) dafür ausgelegt ist, das zweite Verstärkersignal zu verstärken, und
einen Leistungskombinierungsknoten (52, 152), wobei der Leistungskombinierungsknoten (52, 152) dafür ausgelegt ist, das erste und das zweite Verstärkersignal der Hauptleistung-Verstärkerschaltung (55, 155) und der Hilfsleistung-Verstärkerschaltung (56, 156) zu kombinieren, und wobei
die Hauptleistung-Verstärkerschaltung (55, 155) und die Hilfsleistung-Verstärkerschaltung (56, 156) zwischen dem Leistungssplitterknoten (51, 151) und dem Leistungskombinierungsknoten (52, 152) parallel bereitgestellt sind.

2. Antennensystem (210) nach Anspruch 1, wobei das Sende-Empfang-Modul (240) mindestens eine Phasenverschiebungseinheit (260) umfasst, wobei die Phasenverschiebungseinheit (260) dafür ausgelegt ist, die Phase des jeweiligen Übertragungssignals zu steuern, wobei die Richtung der Antennenhauptkeulen der jeweiligen Antennenstruktur (211) von der Phase des jeweiligen Übertragungssignals abhängt, und wobei die Phasenverschiebungseinheit (260) dafür ausgelegt ist, mit dem Antennensystem (210) zwischen dem Signalverarbeitungsmittel (230) und der verstärkenden Schaltung (250) verbunden zu werden.

3. Antennensystem (310) nach einem der vorgehenden Ansprüche, wobei die verstärkende Schaltung (350,450,550,650) weiter eine Vorspannungssteuereinheit (481,482,483,484) umfasst, wobei die Vorspannungssteuereinheit (481,482,483,484) dafür ausgelegt ist, die Funktionalität des Haupt- und des Hilfsverstärkers (453,455,457,459;454,456,458,460) zu steuern.

4. Antennensystem (10) nach einem der Ansprüche 1 bis 3, wobei eine Ausgangleistung des Hauptverstärkers (53, 153) eine lineare Darstellung der Eingangsleistung ist, und eine Ausgangsleistung des ersten Hilfsverstärkers (54, 154) eine nichtlineare Darstellung der Eingangsleistung ist.

5. Antennensystem (10) nach einem der Ansprüche 1 bis 3, wobei eine Ausgangleistung des Hauptverstärkers (53, 153) eine nichtlineare Darstellung der Eingangsleistung ist, und eine Ausgangsleistung des ersten Hilfsverstärkers (54, 154) eine nichtlineare Darstellung der Eingangsleistung ist.

6. Antennensystem (10) nach einem der Ansprüche 1 bis 5, wobei die Ausgangsleistung des Hauptverstärkers (53, 153) und Ausgangsleistung des ersten Hilfsverstärkers (54, 154) für die im Wesentlichen gleiche Leistungsabgabe ausgelegt sind.

7. Antennensystem (10) nach einem der Ansprüche 1 bis 5, wobei die Ausgangsleistung des Hilfsverstärkers (54, 154) im Wesentlichen 5 dB höher als die Ausgangsleistung des Hauptverstärkers (53, 153) ist, so dass, wenn der Hauptverstärker (53, 153) und der Hilfsverstärker (54, 154) bei der jeweiligen höchsten Ausgangsleistung in Betrieb sind, die sich ergebende Ausgangsleistung im Wesentlichen 6 dB höher ist als, wenn nur der Hauptverstärker (53, 153) bei seiner höchsten Ausgangsleistung in Betrieb ist.

8. Antennensystem (10) nach einem der Ansprüche 1 bis 7, wobei das Signalverarbeitungsmittel (30) in Form eines 180-Grad Hybrids ist.

9. Aktive elektrisch lenkbare Antenne (2) umfassend ein primäres Antennensystem und ein Antennensystem (10, 210, 310) nach einem der Ansprüche 1 bis 8.

10. Luft-, See- und Bodeneinheit (1) umfassend die aktive elektrisch lenkbare Antenne nach Anspruch 9.

**11.** Verfahren zur Übertragung eines Abfragesignals bei Verwendung eines Antennensystems (210) nach einem der Ansprüche 1 bis 8, umfassend die folgenden Verfahrensschritte:

• Erzeugen eines Summenabfragesignals und eines Deltaabfragesignals, wobei die Erzeugung von Signalen in einem Sender/Empfänger-Modul (220) ausgeführt wird,
• Zuführen des Summenabfragesignals und des Deltaabfragesignals zu einem Signalverarbeitungsmittel (230), wobei das Signalverarbeitungsmittel (230)
∘ das Summen- und Deltakanalabfragesignal zu Übertragungssignalen kombiniert,
• Zuführen der Übertragungssignale zu mindestens zwei Sende-/Empfang-Modulen (240), wobei ein jeweiliges Sende-/Empfang-Modul (240) mindestens Folgendes ausführt:
∘ Verstärken des jeweiligen Übertragungssignals, wobei die Leistungserhöhung des Übertragungssignals in einer verstärkenden Schaltung (240) umfassend einen Leistungssplitterknoten (251), einen Hauptverstärker (253) einer Hauptleistung-Verstärkerschaltung (255), einen Hilfsverstärker (254) einer Hilfsleistung-Verstärkerschaltung (256) und einen Leistungskombinierungsknoten (252) durchgeführt wird,
• Übertragen der verstärkten Übertragungssignale, wobei die Übertragungssignale durch Antennenstrukturen (211) übertragen werden, wobei jede Antennenstruktur (211) mindestens ein Antennenelement (212) umfasst.

**12.** Verfahren zur Übertragung eines Abfragesignals nach Anspruch 9, wobei ein jeweiliges Sende-/Empfang-Modul (240) mindestens eine Phasenverschiebungseinheit (260) umfasst, wobei die Phasenverschiebungseinheit (260) dafür ausgelegt ist, die Phase von zu übertragenden und/oder zu empfangenden Signalen zu steuern, und wobei das Verfahren weiter den folgenden Verfahrensschritt umfasst:

• Phasenverschiebung des Übertragungssignals,

wobei die Richtung einer Antennenhauptkeule durch die Phasenverschiebung des Übertragungssignals steuerbar ist.

**13.** Steuereinheit zur Steuerung des Antennensystems nach einem der Ansprüche 1 bis 8, wobei die Steuereinheit dafür ausgelegt ist, die Schritte des Verfahrens nach einem der Ansprüche 11 oder 12 auszuführen.

**14.** Computerprogramm umfassend Programmcodemittel zum Ausführen der Schritte des Verfahrens nach einem der Ansprüche 11 oder 12, wenn das Computerprogramm auf einem Computer läuft, der mit dem Antennensystem nach einem der Ansprüche 1 bis 8 verbunden ist.

**15.** Computerlesbares Medium, das ein Computerprogramm nach Anspruch 14 trägt.


**Revendications**

**1.** Système d'antenne (10) pour fournir une fonctionnalité d'identification, comprenant

• deux structures d'antenne (11, 111), chaque structure d'antenne (11, 111) comprenant au moins un élément d'antenne (12, 112),
• un module émetteur-récepteur (20) configuré pour générer un signal d'interrogation de somme et un signal d'interrogation de delta,
• un moyen de traitement de signal (30), le moyen de traitement de signal (30) étant configuré pour traiter les signaux d'interrogation de somme et de delta fournis en signaux de transmission,
• au moins deux modules émission-réception (40, 140), chacun des modules émission-réception (40, 140) étant configuré pour transmettre un signal de transmission fourni par le moyen de traitement de signal (30) au moyen de l'une respective des structures d'antenne (11, 111),

en fonctionnement, le module émetteur-récepteur (20) étant connecté au moyen de traitement de signal (30), le moyen de traitement de signal (30) étant connecté aux modules émission-réception (40, 140), et les modules émission-réception (40,140) étant connectés aux structures d'antenne (11, 111), et dans lequel
chaque module émission-réception (40, 140) est pourvu d'un circuit amplificateur (50, 150), le système d'antenne (10) étant **caractérisé en ce que** chaque
circuit amplificateur (50, 150) comprend :

un nœud séparateur (51, 151), le nœud séparateur (51, 151) étant configuré pour diviser le signal de transmission en au moins un premier et un deuxième signal amplificateur,

un circuit amplificateur de puissance principal (55, 155), le circuit amplificateur de puissance principal (55, 155) comprenant un amplificateur principal (53, 153), l'amplificateur principal (53, 153) étant configuré pour amplifier le premier signal d'amplificateur,

un circuit amplificateur de puissance auxiliaire (56, 156), le circuit amplificateur de puissance auxiliaire (56, 156) comprenant un amplificateur auxiliaire (54, 154), l'amplificateur auxiliaire (54, 154) étant configuré pour amplifier le deuxième signal d'amplificateur, et

un nœud combineur de puissance (52, 152), le nœud combineur de puissance (52, 152) étant configuré pour combiner les premier et deuxième signaux amplificateurs du circuit amplificateur de puissance principal (55, 155) et du circuit amplificateur de puissance auxiliaire (56, 156), et dans lequel

le circuit amplificateur de puissance principal (55, 155) et le circuit amplificateur de puissance auxiliaire (56, 156) sont prévus en parallèle entre le nœud séparateur de puissance (51, 151) et le nœud combineur de puissance (52, 152).

2. Système d'antenne (210) selon la revendication 1, dans lequel chaque module émission-réception (240) comprend au moins une unité de déphasage (260), dans lequel l'unité de déphasage (260) est configurée pour commander la phase du signal de transmission respectif, dans lequel la direction des lobes principaux d'antenne de la structure d'antenne respective (211) dépend de la phase du signal de transmission respectif, et dans lequel l'unité de déphasage (260) est configurée pour être connectée au système d'antenne (210) entre les moyens de traitement de signal (230) et le circuit amplificateur (250).

3. Système d'antenne (310) selon l'une quelconque des revendications précédentes, dans lequel le circuit d'amplification (350,450,550,650) comprend en outre un contrôleur de polarisation (481,482,483,484), dans lequel le contrôleur de polarisation (481,482,483,484) est configuré pour commander la fonctionnalité des amplificateurs principal et auxiliaire (453,455,457,459;454,456,458,460).

4. Système d'antenne (10) selon l'une quelconque des revendications 1 à 3, dans lequel une puissance de sortie de l'amplificateur principal (53, 153) est une représentation linéaire de la puissance d'entrée, et une puissance de sortie du premier amplificateur auxiliaire (54, 154) est une représentation non linéaire de la puissance d'entrée.

5. Système d'antenne (10) selon l'une quelconque des revendications 1 à 3, dans lequel une puissance de sortie de l'amplificateur principal (53, 153) est une représentation non linéaire de la puissance d'entrée, et une puissance de sortie du premier amplificateur auxiliaire (54, 154) est une représentation non linéaire de la puissance d'entrée.

6. Système d'antenne (10) selon l'une quelconque des revendications 1 à 5, dans lequel la puissance de sortie de l'amplificateur principal (53, 153) et la puissance de sortie du premier amplificateur auxiliaire (54, 154) sont dimensionnées pour une puissance de sortie essentiellement égale.

7. Système d'antenne (10) selon l'une quelconque des revendications 1 à 5, dans lequel la puissance de sortie de l'amplificateur auxiliaire (54, 154) est essentiellement supérieure de 5 dB à la puissance de sortie de l'amplificateur principal (53, 153), de sorte que lorsque l'amplificateur principal (53, 153) et les amplificateurs auxiliaires (54, 154) fonctionnent à leur puissance de sortie maximale respective, la puissance de sortie résultante est essentiellement supérieure de 6 dB par rapport au fait que seul l'amplificateur principal (53, 153) fonctionne à sa puissance de sortie maximale.

8. Système d'antenne (10) selon l'une quelconque des revendications 1 à 7, dans lequel le moyen de traitement de signal (30) se présente sous la forme d'un hybride à 180 degrés.

9. Antenne orientable électriquement et active (2), comprenant un système d'antenne primaire et un système d'antenne (10, 210, 310) selon l'une des revendications 1 à 8.

10. Unité (1) à base aérienne, maritime ou terrestre, comprenant l'antenne orientable électriquement et active selon la revendication 9.

11. Procédé de transmission d'un signal d'interrogation en utilisant un système d'antenne (210) selon l'une quelconque des revendications 1 à 8, comprenant les étapes de procédé consistant à :

• générer un signal d'interrogation de somme et un signal d'interrogation de delta, la génération de signaux étant effectuée dans un module émetteur-récepteur (220)
• fournir le signal d'interrogation de somme et le signal d'interrogation de delta à un moyen de traitement de signal (230), le moyen de traitement de signal (230) faisant
  ◦ combiner les signaux d'interrogation de canal de delta et de somme à des signaux de transmission,
• fournir les signaux de transmission à au moins deux modules émission-réception (240), le module émission-réception respectif (240) effectuant au moins :
  ◦ l'amplification du signal de transmission respectif, l'augmentation de puissance du signal de transmission étant effectué dans un circuit d'amplification (240) comprenant un nœud séparateur de puissance (251), un amplificateur principal (253) d'un circuit d'amplification de puissance principal (255), un amplificateur auxiliaire (254) d'un circuit d'amplification de puissance auxiliaire (256) et d'un nœud combineur de puissance (252),
• la transmission des signaux de transmission amplifiés, les signaux de transmission étant transmis par des structures d'antenne (211), chaque structure d'antenne (211) comprenant au moins un élément d'antenne (212).

12. Procédé de transmission d'un signal d'interrogation selon la revendication 9, dans lequel le module émission-réception respectif (240) comprend au moins une unité de déphasage (260), dans lequel ladite unité de déphasage (260) est configurée pour commander la phase de signaux à transmettre et / ou de signaux reçus, et dans lequel le procédé comprend en outre les étapes de :

• déphasage du signal de transmission,

dans lequel, par le déphasage du signal de transmission, la direction d'un lobe principal de l'antenne est contrôlable.

13. Unité de commande pour commander le système d'antenne selon l'une quelconque des revendications 1 à 8, dans laquelle l'unité de commande est configurée pour exécuter les étapes du procédé selon l'une quelconque des revendications 11 ou 12.

14. Programme d'ordinateur comprenant des moyens de code de programme pour exécuter les étapes du procédé selon l'une quelconque des revendications 11 ou 12, lorsque ledit programme est exécuté sur un ordinateur connecté au système d'antenne selon l'une quelconque des revendications 1 à 8.

15. Support lisible par ordinateur portant un programme informatique selon la revendication 14.

FIG. 1

FIG. 2

FIG. 3

EP 3 281 032 B1

FIG. 4

EP 3 281 032 B1

**EP 3 281 032 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8674872 B
- US 3387299 A

- CN 103558594

**Non-patent literature cited in the description**

- **CHOI G.W. et al.** High Efficiency Class-E tuned Doherty Amplifier using GaN HEMT. *IEEE MTT-S Int. Microw. Symp. Dig.,* 2009, 925-928